# FASCICULE DE BREVET EUROPEEN

(11) **EP 3 085 209 B1**
(45) Date de publication et mention de la délivrance du brevet: **22.10.2025**
(21) Numéro de dépôt: 14827758.5
(22) Date de dépôt: 19.12.2014
(51) Int. Cl.: H05K 3/00, H05K 1/02, F21S 41/141, F21S 41/151, F21S 41/19, F21S 45/48, F21V 29/76, F21Y 107/90

(54) **SUPPORT DE DEL AVEC CONNEXION ÉLECTRIQUE PAR PONTAGE**
LED-SUBSTRAT MIT ELEKTRISCHER VERBINDUNG DURCH ÜBERBRÜCKUNG
LED SUBSTRATE WITH ELECTRICAL CONNECTION BY BRIDGING

(30) Priorité: 20.12.2013 FR 1363260
(43) Date de publication de la demande: 26.10.2016
(73) Titulaire: Valeo Vision, 93012 Bobigny Cedex (FR)
(72) Inventeur: DUARTE, Marc, 93250 Villemomble (FR); ZOJCESKI, Zdravko, 92400 Courbevoie (FR)
(74) Mandataire: Valeo Visibility
(86) Numéro de dépôt international: PCT/EP2014/078892
(87) Numéro de publication internationale: WO 2015/092034

(56) Documents cités:
- US-A- 6 161 910
- US-A1- 2009 095 971
- US-A1- 2010 027 284
- US-A1- 2011 084 612
- US-A1- 2011 182 054

## Description

L'invention a trait au domaine de l'éclairage et/ou de la signalisation lumineuse, notamment pour véhicule automobile. Plus particulièrement, l'invention a trait au domaine du montage et de la connexion électrique de sources lumineuses du type diode à électroluminescence (LED). L'invention a trait à un support pour source(s) lumineuse(s), à un module comprenant un tel support et à un procédé d'assemblage du support.

L'utilisation de sources lumineuses du type diode à électroluminescence dans les systèmes d'éclairage et/ou de signalisation lumineuse est de plus en plus répandue. Dans le domaine de l'éclairage et de la signalisation lumineuse automobile, des diodes dites de puissance sont utilisées. Ces dernières sont souvent généralement planes et du type à monter en surface. Le montage de composants en surface consiste à braser les composants d'une carte à sa surface (CMS ou SMD pour « surface mounted device » en anglais), plutôt que d'en faire passer les broches au travers. Les diodes à électroluminescences étant des semi-conducteurs, elles sont affectées par la température : plus elles chauffent, plus leur tension directe de jonction décroît, et leur rendement lumineux se dégrade. Pour des raisons de fiabilité et de performance lumineuse, des mesures visant à assurer une dissipation thermique doivent être mise en œuvre, en particulier pour les modèles de puissance.

Le document de brevet publié FR 2 840 151 A1 divulgue un support de diode électroluminescente de puissance pour système d'éclairage ou de signalisation lumineuse pour véhicule automobile. La diode est collée sur un substrat métallique formant un radiateur. Ce substrat est fixé à une platine isolante électriquement. Il comprend deux échancrures s'étendant, chacune, et de manière opposée, depuis un bord de substrat jusqu'au bord de la diode. Une languette conductrice est disposée dans chacune des deux échancrures afin d'assurer une liaison électrique entre la diode et le circuit imprimé sur la platine, le substrat métallique assurant le refroidissement de la diode. Chacune des languettes est reliée par soudure à une des électrodes de la diode. La configuration de cet enseignement est intéressante dans la mesure où elle permet d'assurer un refroidissement de la diode tout en supportant celle-ci au moyen d'une platine isolante classique. La capacité de refroidissement est toutefois limitée, essentiellement en raison de la taille limitée du substrat métallique. De plus, la précision de positionnement est également limitée compte tenu de l'addition des tolérances de positionnement de la diode par rapport au substrat dissipateur, de ce dernier par rapport à la platine et ensuite de cette dernière par rapport au réflecteur ou au châssis du module d'éclairage ou de signalisation lumineuse.

Le document de brevet publié FR 2 853 200 A1 divulgue, similairement au document précédent, un support de diode électroluminescente de puissance pour système d'éclairage ou de signalisation lumineuse pour véhicule automobile. Similairement au document précédent, la diode est fixée à un substrat métallique apte à dissiper la chaleur produite par la diode. Ce substrat est fixé à une platine en matériau isolant électriquement et comprend deux échancrures opposées au travers desquelles s'étendent, respectivement, deux pattes ou languettes de connexion électrique. Alternativement au procédé de collage de la diode sur le substrat de dissipation thermique divulgué dans le document précédent, la diode de cet enseignement comprend une embase composée essentiellement de cuivre qui est fixée au substrat par soudure laser par points. Ces mesures sont destinées à éviter les inconvénients inhérents à l'utilisation de colle, à savoir le temps de séchage ou de réticulation, les moyens nécessaires à son application, le temps de son application et les moyens de maintien de la diode sur le substrat dissipateur jusqu'à ce que la colle assure sa fixation. Similairement au document précédent, la capacité de refroidissement dans cette construction est limitée, essentiellement en raison de la taille limitée du substrat métallique. Toujours similairement au document précédent, la précision de positionnement de la diode est limitée.

D'autres exemples d'art antérieur pertinent sont divulgués dans les documents US 2011/182054 A1, US 2010/027284 A1, US 2011/084612 A1, US 6 161 910 A et US 2009/095971 A1.

L'invention a pour objectif de proposer un support de diode électroluminescente de puissance, notamment pour système d'éclairage et/ou de signalisation lumineuse pour véhicule automobile, qui assure un meilleur refroidissement et/ou une meilleure précision de positionnement de la ou des diodes.

L'invention a pour objet un support de sources lumineuses pour module d'éclairage et/ou de signalisation lumineuse pour véhicule automobile selon la revendication 1.

En particulier, les diodes électroluminescentes mises en œuvre dans le cadre de la présente invention sont des diodes de puissance montées sur embase en matériau céramique. Elles sont dépourvues de plaque métallique du côté de la face de montage de l'embase. Ces diodes électroluminescentes sont donc constituées d'un composant semi-conducteur électroluminescent placé sur l'embase, avec des moyens qui permettent l'alimentation électrique du composant semi-conducteur tels que des microbilles en or, une couche de soudure en or ou un fil en or.

Ces diodes électroluminescentes sur embase céramique permettent une meilleure gestion des contraintes thermiques et surtout une précision accrue de positionnement vis-à-vis d'un dispositif optique destiné à transmettre la lumière émise par ces diodes, par rapport à d'autres types de conditionnement (package) de diodes électroluminescentes, qui sont plus encombrants et ont une embase avec une surface plus étendue, comportant habituellement une plaque métallique, généralement en cuivre ou aluminium, du coté de la face de contact avec le support.

Dans le cadre de la présente invention, les fils métalliques peuvent être constitués par un fil de section cylindrique, une tresse métallique ou une languette. Ces fils métalliques sont nus, c'est-à-dire sans gaine en matériau isolant.

Selon une caractéristique de l'invention, les fils métalliques s'étendent de manière aérienne, préférentiellement avec des profils de boucle, à distance des surfaces extérieures respectives du circuit de pilotage de l'alimentation et des sources lumineuses.

Dans des cas particuliers, selon les besoins de protection contre les vibrations ou la corrosion, les fils métalliques pourront être recouverts d'une goutte de matière époxy ou silicone, selon la technique de revêtement connue sous le terme anglais « glob top ».

Les faces extérieures du circuit de pilotage de l'alimentation et de la ou des sources lumineuses auxquelles il est relié sont essentiellement à la même hauteur ou du moins présentent une variation de hauteur inférieure à 10mm, préférentiellement 5mm, plus préférentiellement 3mm.

Selon une caractéristique de l'invention, le circuit de pilotage de l'alimentation est supporté par le substrat et comprend un bord en vis-à-vis d'au moins une des sources lumineuses.

Selon un mode avantageux de l'invention, la platine est généralement plane, préférentiellement en résine thermodurcissable renforcée de fibres solides. Alternativement, la platine est un substrat métallique isolé (SMI).

Le circuit électrique peut être imprimé sur la platine.

Selon un mode avantageux de l'invention, la platine est en matériau plastique moulé épousant la forme du substrat. Le circuit électrique peut être noyé dans la platine. Un connecteur peut être formé de manière unitaire avec la platine.

Selon un mode avantageux de l'invention, Le substrat peut comprendre plusieurs orifices.

Selon un mode avantageux de l'invention, l'orifice est traversé par au moins un des fils métalliques relié à la face de la platine en contact avec le substrat et à la ou une des diodes sur la face du substrat opposée à celle sur laquelle est disposée la platine. Alternativement, le fil métallique peut être remplacé par une tresse métallique ou une languette réalisant la connexion électrique.

Selon un mode avantageux de l'invention, la platine comprend une portion s'étendant au travers de l'orifice, ladite portion comprenant au moins un contact électrique, un des fils métalliques s'étendant depuis ledit contact vers la ou une des sources lumineuses sur la face du substrat opposée à celle sur laquelle est disposée la platine. La portion de la platine s'étendant au travers de l'orifice peut être venue de matière avec le reste de la platine, celle-ci pouvant alors être réalisée par moulage de matière plastique. La portion de la platine s'étendant au travers de l'orifice peut également être rapportée, notamment par collage sur le reste de la platine.

Selon un mode avantageux de l'invention, le substrat comprend des ailettes de refroidissement.

Selon un mode avantageux de l'invention, le substrat comprend une première portion formant une paroi supportant la ou les sources lumineuses et une deuxième portion comprenant les ailettes de refroidissement.

Selon un mode avantageux de l'invention, la deuxième portion est disposée essentiellement dans l'alignement de la première portion.

Selon un mode avantageux de l'invention, les première et deuxième portions du substrat sont venues de matière.

Selon un mode avantageux de l'invention, la ou les sources lumineuses sont collées sur le substrat. La colle peut être chargée en argent (Ag) ou en particules de céramique afin de lui conférer des propriétés de conduction thermique.

Selon un mode alternatif de l'invention, la ou les sources lumineuses sont soudées sur le substrat, par exemple au moyen d'une soudure eutectique ou par des méthodes de frittage. Dans ce cas, pour permettre la soudure, on procédera au préalable à une métallisation de la face de montage de l'embase en céramique, par dépôt d'un couche métallique mince, par exemple en aluminium, réalisé par exemple par dépôt chimique en phase vapeur assistée par plasma.

L'invention a également pour objet un module d'éclairage pour véhicule automobile, comprenant: un support de source(s) lumineuse(s); au moins un dispositif optique apte à transmettre les rayons lumineux émis par la ou au moins une des sources lumineuses en un faisceau d'éclairage; remarquable en ce que le support est conforme à l'invention.

Selon l'invention, le dispositif optique est pris seul ou en combinaison parmi : un réflecteur, une lentille de projection, un guide de lumière.

Selon un mode avantageux de l'invention, le module comprend un premier dispositif optique disposé en regard d'une des deux faces du substrat, ladite face supportant au moins une des sources lumineuses et un deuxième dispositif optique disposé en regard de l'autre desdites deux faces, ladite autre face supportant au moins une des sources lumineuses.

Selon un mode avantageux de l'invention, le substrat comprend des ailettes de refroidissement disposées en arrière du ou des dispositifs optiques, tels qu'un réflecteur, par rapport à la direction principale du faisceau d'éclairage.

L'invention peut également avoir pour objet un projecteur ou un dispositif de signalisation lumineuse comprenant un module selon l'invention et/ou un support selon l'invention.

L'invention a également pour objet un procédé d'assemblage d'un support selon l'invention, remarquable par les étapes suivantes: (a) fixation de la ou des sources lumineuses, par collage ou soudure, sur le substrat et mise en place du circuit de pilotage de l'alimentation sur le substrat; et (b) mise en place des fils électriques entre le circuit de pilotage de l'alimentation et la ou les sources lumineuses par pontage et soudage par ultrasons.

A l'étape (a), les opérations de positionnement et fixation de la ou des sources lumineuses et les opérations de mise en place du circuit de pilotage de l'alimentation peuvent être réalisée de manière concomitante ou l'une après l'autre, dans un ordre ou dans l'autre.

Les mesures de l'invention sont intéressantes en ce qu'elles permettent de réaliser le positionnement des sources lumineuses avec une grande précision directement sur le substrat servant de châssis et de pièce de référence pour le dispositif optique auquel il est associé. Le refroidissement des sources lumineuses est également optimisé. Le ou les circuits d'alimentation électrique peut/peuvent être positionné(s) et fixé(s) avec moins de précision que les sources lumineuses, notamment en proportion de la taille de leurs zones de contact avec les fils métalliques. La technologie de connexion par pontage avec des fils ou tresses ou languettes métalliques soudés, préférentiellement par ultrasons mais aussi par soudure laser ou soudure électro-résistive, permet de réaliser ensuite les connexions électriques de manière simple, fiable, économique et compatible avec la liaison avec la fixation par colle ou soudure des sources lumineuses.

D'autres caractéristiques et avantages de la présente invention seront mieux compris à l'aide de la description et des dessins parmi lesquels:
- La figure 1 est une vue en perspective d'un support de diodes à électroluminescence, conforme à un mode de réalisation ne faisant pas partie de l'invention revendiquée, la vue montrant la face supérieure dudit support ;
- La figure 2 est une vue en perspective du support de la figure 1, la vue montrant toutefois la face inférieure dudit support ;
- La figure 3 est une vue en coupe d'un support de diodes à électroluminescence, conforme à un mode de réalisation de l'invention ;
- La figure 4 est une vue en coupe d'une partie de support de diodes à électroluminescence, conforme à un autre mode de réalisation de l'invention, la partie non représentée étant similaire au support de la figure 3 ;
- La figure 5 est une vue en coupe d'une partie de support de diodes à électroluminescence, conforme au mode de réalisation de l'invention illustré sur la figure 4, la partie non représentée étant similaire au support de la figure 3.

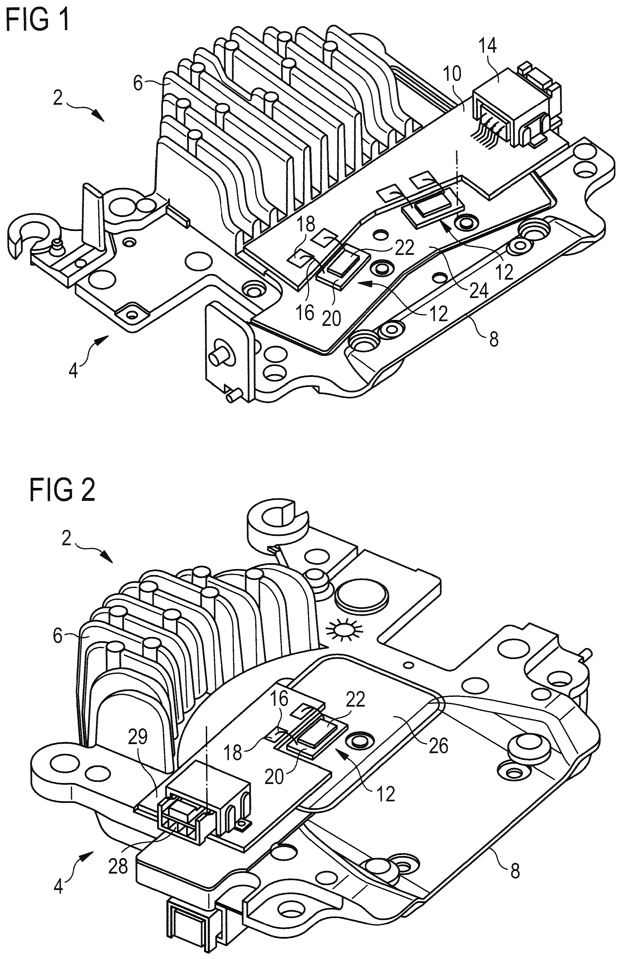

Les figures 1 et 2 illustrent un mode de réalisation ne faisant pas partie de l'invention revendiquée. La figure 1 est une vue en perspective de la face supérieure d'un support de sources lumineuses du type diode à électroluminescence. Le support 2 comprend, essentiellement, un substrat 4 supportant des diodes électroluminescentes 12. Plus précisément le substrat en matériau conducteur thermiquement, comme par exemple de l'aluminium, comprend une première portion 8 généralement mince et plate et une deuxième portion 6 formant des ailettes de refroidissement. Les première et deuxième portions sont préférentiellement unitaires, plus préférentiellement venues de matière.

Les ailettes 6 peuvent s'étendre dans une direction généralement transversale, préférentiellement perpendiculaire, au plan moyen de la première portion.

La face supérieure 24 de la première portion 8 supporte deux diodes électroluminescentes 12. Il s'agit de diodes de puissance, c'est-à-dire de puissance supérieure ou égale à 3 Watt, aptes à être fixées par leur base. Elles comprennent une embase 20 en matériau céramique et une portion optique 22 sur ladite embase 20. On rappellera que l'embase céramique est dépourvue de plaque métallique sur sa face de montage sur le support 2. L'embase des diodes est ici fixée au substrat 8 au moyen de colle thermique, c'est-à-dire au moyen d'une colle présentant des propriétés de transmission de chaleur. Il peut par exemple s'agir d'une colle vendue sous les marques commerciales Epo-tek^{®}, Dow Corning^{®} ou Henkel^{®}.

Une platine 10 recouverte d'un circuit électrique imprimé (non représenté) est disposée également sur la première portion 8 essentiellement plate du substrat 4. La platine présente un profil se conformant aux diodes 12 de manière à les longer à une distance inférieure à 10 mm, préférentiellement 5 mm. Un connecteur 14 est disposé sur la platine de manière à permettre son alimentation via un câble flexible ou un connecteur par montage à pression (press-fit) ou similaire (non représenté). Des zones de contact 18 sont prévues sur la platine 10 en vis-à-vis des diodes 12, ces contacts étant électriquement reliés au circuit imprimé. Les diodes 12 sont reliés électriquement au circuit de pilotage de l'alimentation de la platine 10 via des fils métalliques 16 formant des ponts entre les zones de contact 18 de la platine et les zones de contact correspondantes des diodes. Ces fils 16 sont soudés à ces zones notamment par ultrasons. Il s'agit de la technologie communément désignée par l'expression anglo-saxonne «wire-bonding », ou encore par l'expression « câblage par fil » ou « pontage ». C'est une technique couramment utilisée pour effectuer les connexions électriques entre le boîtier et la puce d'un circuit intégré. Le câblage est simplement réalisé par un fil (ou pont) soudé entre les deux plots de connexion prévus à cet usage sur chacun des éléments. La soudure est généralement réalisée par ultrasons. Le matériau du fil est de l'aluminium, de l'or ou du cuivre ou une combinaison de ces matériaux. Le diamètre du fil peut être compris entre 35 µm et 200 µm. Un seul ou plusieurs fils peuvent être utilisés pour chaque connexion. Eventuellement, une tresse métallique ou une languette métallique peut être utilisé selon l'expression en anglais « ribbon bonding », d'une largeur habituelle de 500 µm et d'épaisseur de 25 µm. Une soudure laser ou électro-résistive peut aussi être envisagée. On précisera ici que dans le cadre de la présente invention, la soudure des fils se fait sans apport de matière, en particulier sans métal d'apport.

La figure 2 est une vue de la face inférieure du support 2 de la figure 1 ne faisant pas partie de l'invention revendiquée. Similairement à la face supérieure, la face inférieure 26 de la portion généralement mince et plate 8 du substrat 4 supporte une diode 12, cette diode pouvant être similaire ou identique à celles situées sur la face inférieure de ladite portion 8 du substrat 4. La diode 12 est fixée également par collage au moyen d'une colle thermique. Une platine 29 est également fixée sur la face supérieure de la portion 8 du substrat 4, cette platine comprenant un circuit préférentiellement imprimé (non représenté) et destiné à alimenter électriquement la diode 12. Des zones de contact 18 similaires à celles de la platine 10 de la face inférieure sont également prévues. La liaison électrique entre le circuit de la platine 29 et la diode 12 est également assurée par des fils soudés 16 formant un pontage. La platine 29 comprend un connecteur 28 destiné à permettre son alimentation à partir d'un câble souple (non représenté).

Pour les deux faces 24 et 26, les fils 16 de la liaison électrique s'étendent de manière généralement courbée à distance des surfaces extérieures des diodes et de la platine. Cette technique de liaison consiste à appliquer une première extrémité d'un fil métallique en contact avec une zone de contact de l'un de la diode et de la platine, et ensuite d'y appliquer des ultrasons afin de l'y souder. Après soudure, le fil peut ensuite être déroulé depuis un outil pour ensuite être coupé et appliqué sur la deuxième des deux zones de contact à relier électriquement. Ces fils sont ainsi rigidement fixés à leurs extrémités aux zones de contact respectives, ces liaisons rigides assurant le maintien du reste du fil dans sa position telle que visible aux figures 1 et 2. Une tresse ou une languette métallique peut être employée en tant que fil. La soudure par laser ou électro-résistive peut aussi être envisagée.

D'un point de vue procédé et méthode d'assemblage, les diodes 12 sont mises en place directement sur le substrat de manière précise, évitant tout cumul de tolérances, notamment lorsqu'elles sont sur un support qui est lui-même positionné sur une platine qui est elle-même positionnée sur le substrat faisant office de pièce de référence. En effet, le substrat comprend des moyens de fixation sur un boîtier (non représenté) et est destiné à recevoir des dispositifs optiques tels que des réflecteurs, des lentilles de projection ou des guides de lumière coopérant avec les diodes. La précision de positionnement peut atteindre une tolérance jusqu'à 30µm, avec un écart type de 5-7µm, inatteignable avec les autres types de conditionnement de diodes électroluminescentes que celles selon l'invention, qui sont montées sur embase en matériau céramique. La ou les platines peuvent être mises en place avant ou après la mise en place de la ou des diodes correspondantes. L'opération de pose des fils métalliques de pontage est réalisée après que la ou les diodes et que la ou les platines soient mises en place.

Le support 2 illustré aux figures 1 et 2 est destiné à former un module d'éclairage bi-fonction. Les diodes de la face supérieure 24 assurent une première fonction d'éclairage à coupure horizontale du type feux de croisement ou encore « code ». La diode de la face inférieure 26 forme un faisceau en complément de celui de la première fonction, formant ainsi une deuxième fonction dite d'éclairage route, c'est-à-dire sans coupure horizontale. Un dispositif optique tel que par exemple un réflecteur de profil parabolique et en forme de demi-coquille est destiné à être disposé sur chacune de deux faces de la portion mince et essentiellement plane 8 du substrat 4. Le substrat 4 forme ainsi le châssis du module d'éclairage.

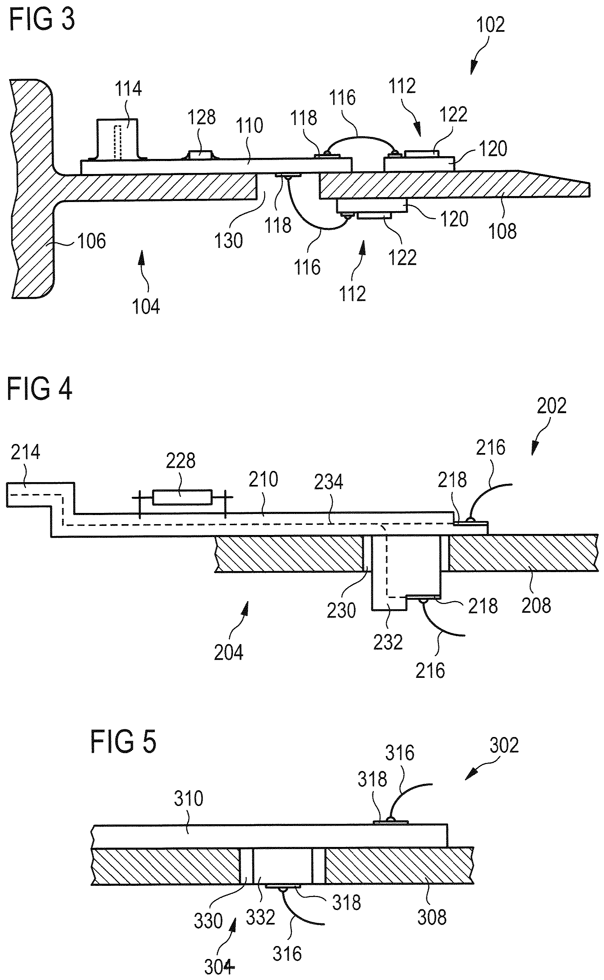

La figure 3 illustre un mode de réalisation de l'invention. Elle est une vue en coupe longitudinale d'un support de diode similaire à celui du premier mode de réalisation. Les numéros de référence du premier mode de réalisation sont utilisés dans le deuxième mode de réalisation pour les éléments identiques ou similaires, ces numéros étant majorés de 100 afin de bien distinguer les deux modes. Il est par ailleurs fait référence pour ces éléments à la description correspondante du premier mode. Des numéros spécifiques compris entre 100 et 200 ont été utilisés pour les éléments spécifiques.

Le module 102 comprend un substrat 104 comprenant, similairement à celui des figures 1 et 2, une première portion 108 généralement mince et plate et une deuxième portion 106 formant des ailettes de refroidissement. Ce mode de réalisation se distingue du premier en ce que le support 102 ne comprend qu'une seule platine d'alimentation 110. Cette dernière s'étend le long de la face supérieure de la portion 108 du substrat 104, au dessus d'un orifice 130 traversant ladite portion 108. La diode 112 disposée sur la face inférieure est reliée électriquement à la platine 110 sur la face supérieure au moyen de fils soudés 116 du type pontage s'étendant depuis la diode 112 au travers de l'orifice 130 jusqu'à des zones de contact 118 sur la face inférieure de la platine 110 en vis-à-vis de l'orifice 130. La ou les diodes sur la face supérieure sont reliées également via des fils métalliques soudés 116, similairement au premier mode de réalisation des figures 1 et 2.

Le diamètre de l'orifice 130 est dimensionné pour permettre une mise en œuvre aisée des fils métalliques soudés 116. Il peut être supérieur à 5mm, préférentiellement 10mm.

Ce mode de réalisation permet de diminuer le nombre nécessaire de platine(s) d'alimentation, plus particulièrement de ne requérir qu'une seule platine pour deux faces d'un substrat, ce qui est particulièrement avantageux.

La figure 4 illustre un autre mode de réalisation de l'invention. Elle est une vue en coupe longitudinale d'un support de diode, similairement à la figure 3 du deuxième mode de réalisation. La vue en coupe est toutefois partielle, le reste du support non représenté étant similaire à celui de la figure 3. Les numéros de référence du deuxième mode de réalisation sont utilisés dans le troisième mode de réalisation pour les éléments identiques ou similaires, ces numéros étant majorés de 100 afin de bien distinguer les deux modes. Il est par ailleurs fait référence pour ces éléments à la description correspondante du premier mode. Des numéros spécifiques compris entre 200 et 300 ont été utilisés pour les éléments spécifiques.

La platine 210 au lieu d'être essentiellement plane comme dans les deux premiers modes de réalisation de l'invention, est en fait un élément en plastique moulé dont la forme se conforme à celle du substrat 204. Le circuit électrique 234 peut par ailleurs être noyé à l'intérieur de la platine 210 ou encore être imprimé ou déposé sur sa surface extérieure. Un connecteur 214 peut être moulé directement avec le reste de la platine, dans la masse de son matériau. Des composants 228 peuvent être prévus, notamment à l'extérieur de la platine afin de permettre leur remplacement ou leur sélection en fonction de divers paramètres de fonctionnement. La platine 210 comprend une portion 232 faisant saillie de sa face intérieure et traversant l'orifice 230. Le circuit électrique 234 peut alors s'étendre au travers de l'orifice 230 à l'intérieur de la matière plastique de la platine 210, plus précisément de la portion en en saillie 232, jusqu'à terminer à une zone de contact 218 en vue d'assurer une connexion électrique avec la diode de la face correspondante. Le matériau plastique utilisé pour la platine 210 est préférentiellement un matériau thermoplastique. Il peut également être renforcé de fibres.

La figure 5 illustre un autre mode de réalisation de l'invention. Elle est une vue en coupe longitudinale d'un support de diode, similairement aux modes de réalisation illustrés sur les figures 3 et 4, respectivement. La vue en coupe est toutefois partielle, le reste du support non représenté étant similaire à celui de la figure 3. Les numéros de référence du troisième mode de réalisation sont utilisés dans le quatrième mode de réalisation pour les éléments identiques ou similaires, ces numéros étant majorés de 100 afin de bien distinguer les deux modes.

La platine 310 est de construction similaire à la platine 110 du deuxième mode de réalisation à la figure 3, à cette différence près qu'elle comprend un ajout 332 sur sa face intérieure et traversant l'orifice 330 de la portion mince et généralement plate 308 du substrat 304. Cet ajout peut être collé sur la face intérieure de la platine 310, cette dernière étant réalisée classiquement en résine époxy renforcée de fibres. L'élément d'ajout 332 est préférentiellement en matériau isolant électriquement, comme par exemple un matériau plastique. Il convient alors de prévoir une liaison électrique entre le circuit imprimé sur la face extérieure de la platine 310 et la zone de contact 318 sur la face extérieure de l'élément ajouté 332. L'élément d'ajout 332 peut également être en matériau conducteur électriquement, par exemple en matériau métallique. Dans ce cas, cet élément doit présenter une taille inférieure à celle de l'orifice 330 afin d'éviter tout contact électrique. Un isolant sur sa face extérieure en vis-à-vis de la surface intérieure de l'orifice peut être prévu. La liaison électrique entre la ou les diodes et l'élément d'ajout 332 est similaire à celle des modes de réalisation précédents. Il en va de même pour la liaison électrique entre la ou les diodes de la face opposée et la platine 310.

De manière générale, il est entendu que la description qui vient d'être faite des différents modes de réalisation est également valable dans le cas d'une inversion des faces supérieure et inférieure.

Toujours de manière générale, il est à noter que le nombre de diodes représentées sur les faces supérieure et inférieure de la portion du substrat des différents modes de réalisation décrits ci-avant est purement exemplatif, ce nombre pouvant varier. Chacune des faces peut ainsi comprendre une, deux ou plus de deux diodes conformément aux dispositions de ces figures.

## Revendications

1. Support (102 ; 202 ; 302) de sources lumineuses pour module d'éclairage et/ou de signalisation lumineuse pour véhicule automobile, comprenant :
- un substrat (104 ; 204, 304) en matériau conducteur thermiquement, préférentiellement en matériau métallique ;
- des sources lumineuses (112 ; 212 ; 312) du type diodes à électroluminescence avec une face de montage sur le substrat (104 ; 204, 304), en contact thermique avec ce dernier, ;
- un circuit de pilotage de l'alimentation électrique (110 ; 210 ; 310) des sources lumineuses ;
dans lequel
le circuit de pilotage de l'alimentation est imprimé sur ou dans une platine (110 ; 210 ; 310) en matériau isolant électriquement disposée sur le substrat (104 ; 204 ; 304),
le circuit de pilotage de l'alimentation (110 ; 210 ; 310) est relié électriquement avec les sources lumineuses (112 ; 212 ; 312) au moyen de fils métalliques soudés en surface (116 ; 216 ; 316), est supporté par le substrat (104 ; 204, 304) et comprend un bord en vis-à-vis d'au moins une des sources lumineuses (112 ; 212 ; 312),
**caractérisé en ce que**
les sources lumineuses (112 ; 212 ; 312) comprennent une embase en céramique ; et
le substrat (104 ; 204 ; 304) comprend deux faces opposées, chacune des deux faces supportant au moins une des sources lumineuses (112 ; 212 ; 312), le substrat comprenant un orifice (130 ; 230, 330) reliant les deux faces et disposé en face de la platine (110 ; 210 ; 310) de manière à permettre la liaison électrique avec la ou les sources lumineuses sur la face du substrat opposée à celle sur laquelle est disposée la platine.

2. Support (102 ; 202 ; 302) selon la revendication 1, **caractérisé en ce que** les fils métalliques (116 ; 216 ; 316) s'étendent de manière aérienne, préférentiellement avec des profils de boucle, à distance des surfaces extérieures respectives du circuit de pilotage de l'alimentation (110 ; 210 ; 310) et des sources lumineuses (212 ; 312).

3. Support (202) selon la revendication 1 ou la revendication 2, **caractérisé en ce que** la platine (210) est en matériau plastique moulé épousant la forme du substrat (204).

4. Support (102) selon l'une des revendications 1 à 3, **caractérisée en ce que** la platine (110) est généralement plane, préférentiellement en résine thermodurcissable renforcée de fibres solides.

5. Support (102) selon l'une des revendications 1 à 4, **caractérisé en ce que** l'orifice (130) est traversé par au moins un des fils métalliques (116) relié à la face de la platine (110) en contact avec le substrat (104) et à une des diodes (112) sur la face du substrat (104) opposée à celle sur laquelle est disposée la platine (110).

6. Support (202 ; 302) l'une des revendications 1 à 4, **caractérisé en ce que** la platine (210 ; 310) comprend une portion (232 ; 332) s'étendant au travers de l'orifice (230 ; 330), ladite portion comprenant au moins un contact électrique (218 ; 318), un des fils métalliques (216 ; 316) s'étendant depuis ledit contact vers une des sources lumineuses (216 ; 316) sur la face du substrat (204 ; 304) opposée à celle sur laquelle est disposée la platine (210 ; 310).

7. Support (102 ; 202 ; 302) selon l'une des revendications 1 à 5, **caractérisé en ce que** le substrat (104 ; 204 ; 304) comprend des ailettes de refroidissement (106 ; 206 ; 306).

8. Support (102 ; 202 ; 302) selon l'une des revendications la revendication 7, **caractérisé en ce que** le substrat (104 ; 204 ; 304) comprend une première portion (108 ; 208 ; 308) formant une paroi supportant les sources lumineuses et une deuxième portion (106; 206 ; 306) comprenant les ailettes de refroidissement.

9. Support (102 ; 202 ; 302) selon la revendication 8, **caractérisé en ce que** la deuxième portion (106; 206 ; 306) est disposée essentiellement dans l'alignement de la première portion.

10. Support (102 ; 202 ; 302) selon l'une des revendications 8 et 9, **caractérisé en ce que** les première (108 ; 208 ; 308) et deuxième portions (106 ; 206 ; 306) du substrat sont venues de matière.

11. Support (102 ; 202 ; 302) selon l'une des revendications 1 à 10, **caractérisé en ce que** les sources lumineuses (112 ; 212 ; 312) sont collées ou soudées sur le substrat (104 ; 204 ; 304).

12. Module d'éclairage pour véhicule automobile, comprenant :
- un support (102 ; 202 ; 302) de sources lumineuses (112 ; 212 ; 312) ;
- au moins un réflecteur apte à réfléchir les rayons lumineux émis par au moins une des sources lumineuses en un faisceau d'éclairage ;
**caractérisé en ce que**
- le support est conforme à l'une des revendications 1 à 11, et
- le module d'éclairage comprend un premier réflecteur disposé en regard d'une des deux faces du substrat (104 ; 204 ; 304), ladite face supportant au moins une des sources lumineuses et un deuxième réflecteur disposé en regard de l'autre desdites deux faces, ladite autre face supportant au moins une des sources lumineuses.

13. Module d'éclairage selon la revendication 12, **caractérisé en ce que** le substrat (104 ; 204 ; 304) comprend des ailettes de refroidissement (106 ; 206 ; 306) et **en ce que** les ailettes de refroidissement (106 ; 206 ; 306) sont disposées en arrière du ou des réflecteurs par rapport à la direction principale du faisceau d'éclairage.

14. Procédé d'assemblage d'un support selon l'une des revendications 1 à 11, **caractérisé par** les étapes suivantes :
(a) fixation des sources lumineuses (112 ; 212 ; 312), par collage ou soudure, sur le substrat (104 ; 204 ; 304) et mise en place du circuit de pilotage de l'alimentation (110 ; 210, 310) sur le substrat (104 ; 204 ; 304) ;
(b) mise en place des fils électriques (116 ; 216 ; 316) entre le circuit de pilotage de l'alimentation (110 ; 210, 310) et les sources lumineuses (112 ; 212 ; 312) par pontage et soudage, par ultrasons, soudure laser ou électro-résistive.

## Patentansprüche

1. Eine Halterung (2; 102; 202; 302) für Lichtquellen für ein Beleuchtungs- und/oder Lichtsignalmodul für ein Kraftfahrzeug, umfassend:
- ein Substrat (104; 204, 304) aus wärmeleitendem Material, vorzugsweise aus einem metallischen Material;
- Lichtquellen (112; 212; 312) vom Typ Leuchtdiode mit einer Fläche zur Befestigung auf dem Substrat (104; 204, 304) in thermischem Kontakt mit diesem;
- eine Schaltung zur Steuerung der Stromversorgung (110; 210; 310) der Lichtquellen,
wobei
die Schaltung zur Steuerung der Stromversorgung auf oder in einer Platine (110; 210; 310) aus einem elektrisch isolierenden Material gedruckt ist, wobei die Platine auf dem Substrat (104; 204; 304) positioniert ist
die Schaltung zum Steuern der Stromversorgung (110; 210; 310) über Metalldrähte, die an die Oberfläche (116; 216; 316) gelötet sind, elektrisch mit den Lichtquellen (112; 212; 312) verbunden ist, von dem Substrat (104; 204; 304) getragen wird und eine Kante aufweist, die der oder mindestens einer der Lichtquelle(n) (112; 212; 312) zugewandt ist,
**dadurch gekennzeichnet, dass**
die Lichtquelle(n) (112; 212; 312) eine Keramikbasis umfasst; und
das Substrat (104; 204, 304) zwei gegenüberliegende Flächen aufweist, wobei jede der beiden Flächen mindestens eine der Lichtquellen (112; 212; 312) trägt, wobei das Substrat eine Öffnung (130; 230, 330) aufweist, die die beiden Seiten verbindet und gegenüber der Platine (110; 210; 310) positioniert ist, um die elektrische Verbindung mit der einen oder den mehreren Lichtquellen auf der Seite des Substrats zu ermöglichen, die derjenigen gegenüberliegt, auf der die Platine positioniert ist.

2. Der Träger (102; 202; 302) nach Anspruch 1, **dadurch gekennzeichnet, dass** sich die Metalldrähte (116; 216; 316) vorzugsweise mit Schleifenprofilen luftgestützt v , von den jeweiligen Außenflächen der Schaltung zur Steuerung der Stromversorgung (110; 210; 310) und der Lichtquellen (212; 312) zu steuern.

3. Die Halterung (202) gemäß Anspruch 1 oder 2, **dadurch gekennzeichnet, dass** die Platine (210) aus einem geformten Kunststoffmaterial besteht, das sich an die Form des Substrats (204) anschmiegt.

4. Die Halterung (102) gemäß den Ansprüchen 1 bis 3, **dadurch gekennzeichnet, dass** die Platte (110) im Allgemeinen planar ist und vorzugsweise aus einem mit festen Fasern verstärkten duroplastischen Harz besteht.

5. Die Halterung (102) gemäß einem der Ansprüche 1 bis 4, **dadurch gekennzeichnet, dass** mindestens einer der Metalldrähte (116), der mit der Seite der Platte (110) verbunden ist, die mit dem Substrat (104) in Kontakt steht, und mit der oder einer der Dioden(112) auf der dem Platten (110) gegenüberliegenden Seite des Substrats (104) verbunden ist, durch die Öffnung (130) verläuft.

6. Die Halterung (202; 302) gemäß einem der Ansprüche 1 bis 4, **dadurch gekennzeichnet, dass** die Platte (210; 310) einen Abschnitt (232; 332) aufweist, der sich durch die Öffnung (230; 330) erstreckt, wobei dieser Abschnitt mindestens einen elektrischen Kontakt (218; 318) umfasst, wobei sich einer der Metalldrähte (216; 316) von diesem Kontakt zu der oder einer der Lichtquelle(n) (216; 316) auf der Seite des Substrats (204; 304) erstreckt, die derjenigen gegenüberliegt, auf der die Platte (210; 310) positioniert ist.

7. Die Halterung (102; 202; 302) gemäß einem der Ansprüche 1 bis 5, **dadurch gekennzeichnet, dass** das Substrat (104; 204; 304) die Kühlrippen (106; 206; 306) umfasst.

8. Die Halterung (102; 202; 302) gemäß Anspruch 7, **dadurch gekennzeichnet, dass** das Substrat (104; 204; 304) einen ersten Abschnitt (108; 208; 308), der eine Wand bildet, die die eine oder mehrere Lichtquellen trägt, und einen zweiten Abschnitt (106; 206; 306) umfasst, der die Kühlrippen umfasst.

9. Die Halterung (102; 202; 302) gemäß Anspruch 8, **dadurch gekennzeichnet, dass** der zweite Abschnitt (106; 206; 306) im Wesentlichen in einer Linie mit dem ersten Abschnitt positioniert ist.

10. Die Halterung (102; 202; 302) gemäß einem der Ansprüche 8 und 9, **dadurch gekennzeichnet, dass** der erste (108; 208; 308) und der zweite (106; 206; 306) Abschnitt des Substrats aus einem Stück desselben Materials hergestellt sind.

11. Die Halterung (102; 202; 302) gemäß einem der Ansprüche 1 bis 10, **dadurch gekennzeichnet, dass** die Lichtquellen (112; 212; 312) mit dem Substrat (104; 204; 304) verbunden oder verlötet sind.

12. Beleuchtungsmodul für ein Kraftfahrzeug, umfassend:
- einen Träger (102; 202; 302) für Lichtquellen (112; 212; 312);
- mindestens einen Reflektor, der die von mindestens einer der Lichtquellen emittierten Lichtstrahlen in einen Beleuchtungsstrahl reflektieren kann;
**dadurch gekennzeichnet, dass**
- der Träger gemäß einem der Ansprüche 1 bis 11 ist und
- das Beleuchtungsmodul einen ersten Reflektor umfasst, der einer der beiden Flächen des Substrats (104; 204; 304) zugewandt ist, wobei diese Fläche mindestens eine der Lichtquellen trägt, sowie einen zweiten Reflektor, der der anderen der beiden Flächen zugewandt ist, wobei diese andere Fläche mindestens eine der Lichtquellen trägt.

13. Das Beleuchtungsmodul nach Anspruch 12, **dadurch gekennzeichnet, dass** das Substrat (104; 204; 304) Kühlrippen (106; 206; 306) umfasst und dass die Kühlrippen (106; 206; 306) in Bezug auf die Hauptrichtung des Beleuchtungsstrahls hinter dem Reflektor oder den Reflektoren positioniert sind.

14. Verfahren zum Zusammenbau einer Halterung gemäß einem der Ansprüche 1 bis 11, **gekennzeichnet durch** die folgenden Schritte:
(a) Befestigen der einen oder mehreren Lichtquellen (112; 212; 312) durch Kleben oder Löten an dem Substrat (104; 204; 304) und Anordnen der Schaltung zum Steuern der Stromversorgung (110; 210, 310) auf dem Substrat (104; 204; 304);
(b) Anordnen der elektrischen Drähte (116; 216; 316) zwischen der Schaltung zum Steuern der Stromversorgung (110; 210, 310) und der einen oder den mehreren Lichtquellen (112; 212; 312) durch Überbrücken und Löten unter Verwendung von Ultraschall, Laser oder elektrischem Widerstandslöten.

## Claims

1. A support (2; 102; 202; 302) for light sources for a lighting and/or light-signaling module for an automotive vehicle, comprising:
- a substrate (104; 204, 304) made of heat-conducting material, preferably made of a metal material;
- light sources (112; 212; 312) of light-emitting diode type with one face for mounting on the substrate (104; 204, 304), in thermal contact with the latter;
- a circuit for controlling the electrical power supply (110; 210; 310) of the light sources,
wherein
the circuit for controlling the power supply is printed on or in a board (110; 210; 310) made of an electrically insulating material, which board is positioned on the substrate (104; 204; 304)
the circuit for controlling the power supply (110; 210; 310) is electrically connected to the light sources (112; 212; 312) by means of metal wires that are soldered to the surface (116; 216; 316), is borne by the substrate (104; 204; 304) and comprises an edge that is facing the, or at least one of the, light source(s) (112; 212; 312),
**characterized in that**
the light source s(112; 212; 312) comprise a ceramic base; and
the substrate (104; 204, 304) comprises two opposite faces, each of the two faces bearing at least one of the light sources (112; 212; 312), the substrate comprising an orifice (130; 230, 330) that connects the two faces and is positioned opposite the board (110; 210; 310) so as to allow the electrical connection with the one or more light sources on the face of the substrate opposite that on which the board is positioned.

2. The support (102; 202; 302) as claimed in claim 1, **characterized in that** the metal wires (116; 216; 316) aerially extend, preferably with looping profiles, away from the respective outer surfaces of the circuit for controlling the power supply (110; 210; 310) and of the light sources (212; 312).

3. The support (202) as claimed in claim 1 or 2, **characterized in that** the board (210) is made of a molded plastic material hugging the form of the substrate (204).

4. The support (102) as claimed in claims 1 to 3, **characterized in that** the board (110) is generally planar, preferably made of a thermosetting resin reinforced with solid fibers.

5. The support (102) as claimed in one of claims 1 to 4, **characterized in that** at least one of the metal wires (116), connected to the face of the board (110) that is in contact with the substrate (104) and to the, or one of the, diode(s) (112) on the face of the substrate (104) opposite that on which the board (110) is positioned, passes through the orifice (130).

6. The support (202; 302) as claimed in one of claims 1 to 4, **characterized in that** the board (210; 310) comprises a portion (232; 332) that extends through the orifice (230; 330), said portion comprising at least one electrical contact (218; 318), one of the metal wires (216; 316) extending from said contact to the, or one of the, light source(s) (216; 316) on the face of the substrate (204; 304) opposite that on which the board (210; 310) is positioned.

7. The support (102; 202; 302) as claimed in one of claims 1 to 5, **characterized in that** the substrate (104; 204; 304) comprises the cooling fins (106; 206; 306).

8. The support (102; 202; 302) as claimed in claims 7, **characterized in that** the substrate (104; 204; 304) comprises a first portion (108; 208; 308) that forms a wall bearing the one or more light sources and a second portion (106; 206; 306) comprising the cooling fins.

9. The support (102; 202; 302) as claimed in claim 8, **characterized in that** the second portion (106; 206; 306) is positioned essentially in line with the first portion.

10. The support (102; 202; 302) as claimed in either of claims 8 and 9, **characterized in that** the first (108; 208; 308) and second (106; 206; 306) portions of the substrate are made in one piece of the same material.

11. The support (102; 202; 302) as claimed in one of claims 1 to 10, **characterized in that** the light sources (112; 212; 312) are bonded or soldered to the substrate (104; 204; 304).

12. A lighting module for an automotive vehicle, comprising:
- a support (102; 202; 302) for light sources (112; 212; 312);
- at least one reflector capable of reflecting the light rays emitted by at least one of the light sources into a lighting beam;
**characterized in that**
- the support is in accordance with one of claims 1 to 11, and
- the lighting module comprises a first reflector positioned facing one of the two faces of the substrate (104; 204; 304), said face bearing at least one of the light sources, and a second reflector positioned facing the other of said two faces, said other face bearing at least one of the light sources..

13. The lighting module as claimed in claim 12, **characterized in that** the substrate (104; 204; 304) comprises cooling fins (106; 206; 306) and **in that** the cooling fins (106; 206; 306) are positioned behind the **reflector or reflectors** with respect to the main direction of the lighting beam.

14. A method for assembling a support as claimed in one of claims 1 to 11, **characterized by** the following steps:
(a) fixing the one or more light sources (112; 212; 312), by bonding or soldering, to the substrate (104; 204; 304) and placing the circuit for controlling the power supply (110; 210, 310) on the substrate (104; 204; 304);
(b) placing the electrical wires (116; 216; 316) between the circuit for controlling the power supply (110; 210, 310) and the one or more light sources (112; 212; 312) by bridging and soldering using ultrasound, or laser or electric resistance soldering.
